Europäisches Patentamt

European Patent Office

Office européen des brevets

(11) Publication number: **0 144 143**
**B1**

## EUROPEAN PATENT SPECIFICATION

(45) Date of publication of patent specification: **03.01.90**

(51) Int. Cl.⁵: **H 03 G 1/00**

(21) Application number: **84307351.1**

(22) Date of filing: **25.10.84**

(54) Circuit arrangement for adjusting sound volume.

(30) Priority: **28.10.83 JP 202409/83**

(43) Date of publication of application:
**12.06.85 Bulletin 85/24**

(45) Publication of the grant of the patent:
**03.01.90 Bulletin 90/01**

(84) Designated Contracting States:
**DE FR GB**

(56) References cited:
**DD-A- 131 608**
**DE-A-2 926 011**
**DE-A-3 019 964**
**GB-A-2 091 054**
**US-A-4 270 177**

**PATENT ABSTRACTS OF JAPAN, vol. 4, no. 87
(E-16)569r, 21th June 1980; & JP - A - 55 52613**

**PATENT ABSTRACTS OF JAPAN, VOL. 7, NO.
267(E-213)1412r, 29TH NOVEMBER 1983; & JP -
A - 58 150 309**

(73) Proprietor: **VICTOR COMPANY OF JAPAN,
LIMITED
3-12, Moriya-cho
Kanagawa-ku Yokohama (JP)**

(72) Inventor: **Kitamura, Masatsugu
1046-15 Tomuro
Atsugi-shi Kanagawa-ken (JP)**
Inventor: **Matsushige, Takashi
1-1-40 Fujimigaoka Ninomiya-cho
Naka-gun Kanagawa-ken (JP)**
Inventor: **Sakurai, Yukimitsu
3-1-15 Yamato Higashi
Yamato-shi Kanagawa-ken (JP)**

(74) Representative: **Senior, Alan Murray et al
J.A. KEMP & CO 14 South Square Gray's Inn
London WC1R 5EU (GB)**

Courier Press, Leamington Spa, England.

**Description**

This invention relates generally to audio signal processing, and particularly to a circuit arrangement for adjusting sound volume of an input audio signal.

US—A—4 270 177 discloses a digital amplitude control unit in which an analogue control signal is converted to a digital signal by an A/D converter, which digital signal is then multiplied with the audio information to produce the desired output amplitude.

In a sound volume adjusting apparatus arranged to vary transfer gain of an audio signal in a stepwise manner, such that the amplitude of the audio signal is controlled by way of a digital control unit, click noise, which is apt to occur when sound volume is changed stepwise, has hitherto been a problem.

Conventionally, countermeasure has been adopted such that sound volume adjustment is slowly performed using a relatively long period of time so as to resolve the above problem. However, it is often required to perform sound volume adjustment within a short period of time, and an improvement has been desired.

Summary of the invention

The present invention has been developed in order to reduce the above-described drawbacks inherent to the conventional sound volume adjusting apparatus.

According to the present invention there is provided a circuit arrangement for sound volume adjustment, including: a multipler responsive to an input audio signal for adjusting the amplitude of said audio signal by performing multiplication such that said audio is multiplied by a variable control signal; a manipulative portion for producing said variable control signal indicative of an intended sound volume of said audio signal; and an analogue-to-digital converter for converting said variable control signal into a digital control signal to be fed to said multiplier, characterized in that it further comprises:

(a) a zero detector responsive to said audio signal for producing an output signal when an instantaneous value of said audio signal is nearly zero; and

(b) a latch for latching said digital control signal from said analog-to-digital converter and for continuously outputting the latched control signal to said multiplier, said latch being responsive to said output signal from said zero detector so that latching is effected only in the presence of said output signal.

The invention enables provision of a circuit arrangement for sound volume adjusting which suffers less from the occurrence of click noise on gain control.

With the present invention an instant where an instantaneous value of an input audio signal to be controlled becomes zero or nearly zero is detected by way of a zero detector, and a digital signal to be fed to a multiplier functioning as a gain control circuit is updated or renewed in response to an output signal from the zero detector so that gain is changed when the instantaneous value of the input audio signal is very small.

Patent Abstracts of Japan, vol. 4, No. 87 (E-16) [569], 21st June 1980, referring to JP—A—5552613 discloses a circuit whereby latching of a new, single-bit value is only permitted at, or near signal zero, thus permitting transient-free on/off switching of an audio signal.

Brief description of the drawings

The object and features of the present invention will become more readily apparent from the following detailed description of the preferred embodiments taken in conjunction with the accompanying drawings in which:

Fig. 1 is a schematic block diagram of a first embodiment of the circuit according to the present invention;

Fig. 2 is a schematic block diagram of a second embodiment of the circuit according to the present invention; and

Fig. 3 is a timing chart useful for understanding the operation of the circuit according to the present invention.

The same or corresponding elements and parts are designated at like reference numerals throughout the drawings.

Detailed description of the invention

An audio signal whose amplitude is to be controlled for sound volume adjustment may be an analog signal or a digital signal, and the present invention is applicable to either cases. In known sound volume adjusting apparatus, an input audio signal, which is either an analog signal or a digital signal, is multipled by a digital signal representing an intended sound volume. The present invention is adapted to such a sound volume adjusting circuit using a multiplier.

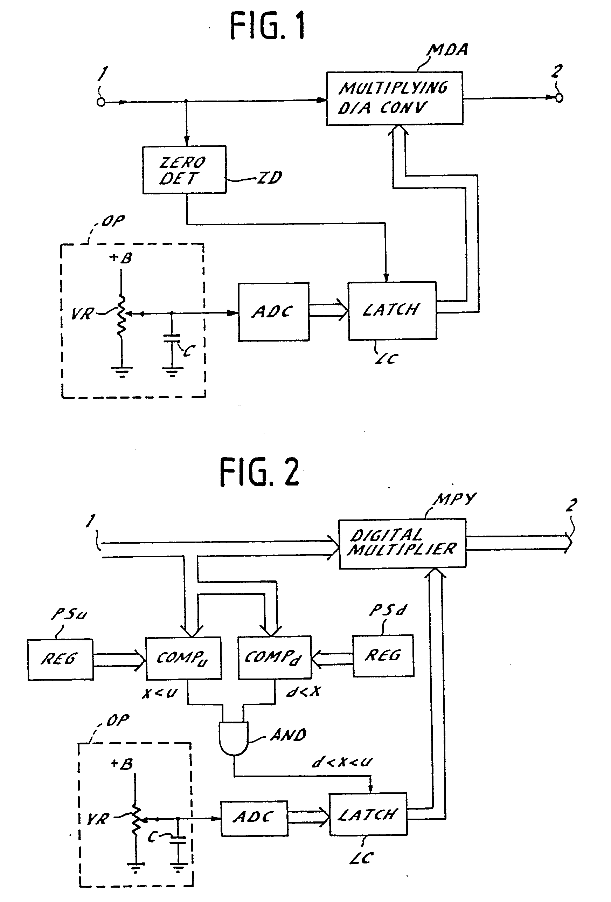

Referring now to Figs. 1 and 2, first and second embodiments of the present invention are respectively shown. The first embodiment circuit arrangement is used for processing an analog audio signal, while the second embodiment circuit arrangement is used for processing a digital audio signal.

In Figs. 1 and 2, the reference 1 is an input terminal for an audio signal which is to be controlled and is an objective of sound volume control, and the reference 2 is an output terminal of an audio signal whose sound volume has been controlled.

In Figs. 1 and 2, the reference OP is a manipulative portion for sound volume adjustment; ADC, an A/D converter; LC, a latch; ZD, a zero detector which is arranged to produce an output signal when the instantaneous value of the audio signal to be controlled is low and is within a predetermined range close to zero. The reference MDA in Fig. 1 is a multiplying digital-to-analog (D/A) converter, and the reference MPY in Fig. 2 is a digital multiplier. The multiplying D/A converter MDA is a D/A converter having an input terminal for receiving a varying reference voltage. As the multiplying D/A converter may be used an integrated circuit known as AD1408 or AD1508 manufactured by Analog Devices, Inc., while as the digital multiplier may be used an integrated circuit known as ADSP-1012 also manufactured by Analog Devices, Inc.

In the respective embodiments illustrated in Figs. 1 and 2, while the manipulative portion OP is shown to be constructed of a variable resistor VR and a capacitor C, it is a matter of course that the manipulative portion OP can have other structure when practicing the present invention. For instance, a digital signal indicative of an intended sound volume may be separately produced by way of an external circuit, and such an external digital signal may be directly applied to the latch LC.

When a movable contact of the variable resistor VR of the manipulative portion OP shown in respective diagrams is adjusted for sound volume adjustment, a voltage according to an adjusted position of the movable contact of the variable resistor VR is outputted from the manipulative portion OP to be fed to the A/D converter ADC.

A digital signal outputted from the above-mentioned A/D converter ADC is fed to the latch LC. Then the latch LC receives the digital signal fed from the A/D converter ADC to the latch LC and at an instant where an output signal from the zero detector ZD is applied thereto, holds the digital signal.

Subsequently, the output signal from the above-mentioned latch LC is fed to the multiplying D/A converter MDA in the first embodiment of Fig. 1, and to the digital multiplier MPY in the second embodiment of Fig. 2. In the multiplying D/A converter MDA in the first embodiment of Fig. 1, the analog signal fed from the input terminal 1 is multiplied by the digital signal outputted from the latch LC so as to output a signal to the output terminal 2, which output signal is in a state that the sound volume of the audio signal fed to the input terminal 1, having an analog signal form, has been adjusted in accordance with the manipulation in the manipulative portion OP. In the digital multiplier MPY in the second embodiment of Fig. 2, the digital signal fed from the input terminal 1 is multiplied by the digital signal outputted from the latch LC so as to output a signal to the output terminal 2, which output signal is in a state that the sound volume of the audio signal fed to the input terminal 1, having a digital signal form, has been adjusted in accordance with the manipulation in the manipulative portion OP.

In the sound volume adjusting apparatus shown in Figs. 1 and 2, an instant where the latch LC receives and holds a digital signal from the A/D converter ADC is an instant where a signal from the zero detector ZD is applied thereto, and the instant where a signal is applied from the zero detector ZD is an instant where the instantaneous value of the audio signal fed to the input terminal 1 as an objective of sound volume adjustment in the apparatus according to the present invention is at zero or close thereto.

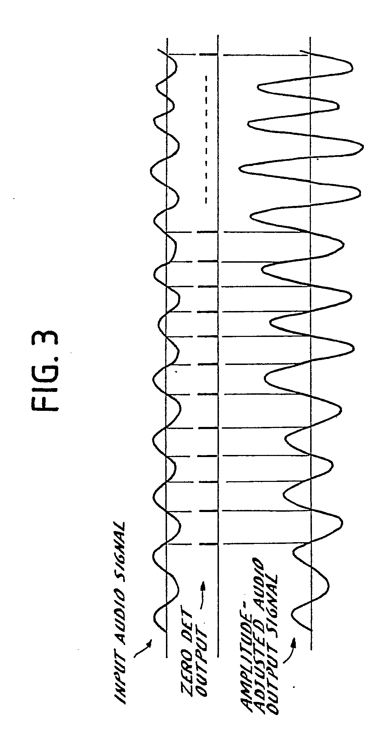

Fig. 3 is a timing chart for the description of the operation of the sound volume adjusting apparatus according to the present invention. In Fig. 3, the audio signal fed to the input terminal 1 as an objective of sound volume adjustment, the output signal from the zero detector ZD, and the output signal of the multiplying D/A converter MDA are shown. Since the zero detector ZD produces an output pulse signal each time the instantaneous value of the input audio signal equals zero, the latch LC responsive to the output signal from the zero detector ZD is controlled so that digital data indicative of intended sound volume from the A/D converter ADC is latched in the presence of the output signal from the zero detector ZD. This digital data latched in the latch LC is not changed until subsequent output signal from the zero detector ZD is applied, and is fed to the multiplying D/A converter MDA for sound volume control. Let us assume that the movable contact of the variable resistor VR of the manipulative portion OP has been manipulated to change a demand for sound volume. An analog voltage fed to the A/D converter ADC is changed and digital output fed to the latch LC is changed accordingly. This changed digital data or signal. The instant that the latch LC receives and holds the new digital signal from the A/D converter ADC, namely, the instant where the amplitude of the audio signal is actually changed by sound volume adjustment, is the instant where the signal from the zero detector ZD is applied to the latch LC when the instantaneous value of the audio signal fed to the input terminal 1 as an objective of sound volume adjustment is low and is within a predetermined range close to zero irrespective of the timing of the manipulation for sound volume adjustment. Therefore, in the sound volume adjusting apparatus according to the present invention, click noise or the like does not occur due to sound volume adjustment.

As the zero detector ZD may be used known or well known circuits which are capable of producing an output signal when an instantaneous value of an audio signal is low and is within a predetermined range close to zero.

The zero detector ZD shown in Fig. 2 is an example which handles a digital signal. In Fig. 2, the references COMPu and COMPd are comparators; PSu and PSd, registers; AND, an AND gate. A numerical value u is set in the register PSu, while another numerical value d is set in the other register PSd where $u > d$.

The comparator COMPu produces an output signal when a numerical value X having a relationship of $u > X$ with respect to the numerical value u set in the register PSu is inputted, while the other comparator COMPd produces an output signal when a numerical value X having a relationship of $X > d$ with respect to the numerical value d set in the register PSd is inputted.

Therefore, when the numerical value X of the audio signal fed to the input terminal 1 as an objective of sound volume adjustment satisfies the relationship of d<X<u, an output signal is fed from the AND gate AND to the latch LC.

If the numerical value d is set to a value slightly smaller than zero, and if the numerical value u is set to a value slightly greater than zero, then the signal from the AND gate AND is fed to the latch LC only when the numerical value X of the audio signal fed to the input terminal 1 as an objective of sound volume adjustment is low and is within a predetermined range close to zero, and then the latch LC receives and holds the new digital signal from the A/D converter ADC so that the amplitude of the audio signal is changed by the sound volume adjustment.

As is apparent from the above detailed description, since the present invention provides a sound volume adjusting apparatus of the type arranged to vary transfer gain of an audio signal in a stepwise manner, comprising means for varying transfer gain of said audio signal when an instantaneous value of said audio signal to be controlled is low and is within a predetermined range close to zero, an instant where the amplitude of an audio signal is actually changed is set at a time in which the instantaneous value of the audio signal fed to the input terminal 1 as an objective of sound volume adjustment is low and is within a predetermined range close to zero, and therefore, click noise does not occur during sound volume adjustment in the sound volume adjusting apparatus according to the present invention. As a result, the above-mentioned problem inherent to the conventional apparatus is satisfactorily resolved according to the present invention apparatus.

## Claims

1. A circuit arrangement for sound volume adjustment, including: a multiplier (MDA or MPY) responsive to an input audio signal for adjusting the amplitude of said audio signal by performing multiplication such that said audio is multiplied by a variable control signal; a manipulative portion (OP) for producing said variable control signal indicative of an intended sound volume of said audio signal; and an analogue-to-digital converter (ADC) for converting said variable control signal into a digital control signal to be fed to said multiplier, characterized in that it further comprises:

(a) a zero detector (ZD) responsive to said audio signal for producing an output signal when an instantaneous value of said audio signal is nearly zero; and

(b) a latch (LC) for latching said digital control signal from said analog-to-digital converter (ADC) and for continuously outputting the latched control signal to said multiplier (MDA or MPY), said latch (LC) being responsive to said output signal from said zero detector (ZD) so that latching is effected only in the presence of said output signal.

2. A circuit arrangement as claimed in Claim 1,

wherein said audio signal is an analog signal and said multiplier (MDA or MPY) is a multiplying digital-to-analog converter (MDA) for multiplying said analog signal by said digital control signal and outputting a resultant analog signal.

3. A circuit arrangement as claimed in Claim 1, wherein said audio signal is a digital signal and said multiplier (MDA or MPY) is a digital multiplier (MPY).

4. A circuit arrangement as claimed in Claim 1, 2 or 3, wherein said zero detector (ZD) is arranged to produce said output signal when the value of said audio signal is within a predetermined range including zero level.

## Patentansprüche

1. Schaltungsanordnung zur Lautstärkeregelung, mit einem auf ein eingegebenes Tonfrequenzsignal ansprechenden Multiplizierer (MDA; MPY) zum Einstellen der Amplitude des Tonfrequenzsignals durch eine Multiplikation in der Weise, daß das Tonfrequenzsignal mit einem veränderbaren Steuersignal multipliziert wird, einem Bedienungsteil (OP) zur Abgabe des veränderbaren Steuersignals, das eine angestrebte Lautstärke des Tonfrequenzsignals angibt, und einem Analog/Digital-Wandler (ADC) zum Umsetzen des veränderbaren Steuersignals in ein dem Multiplizierer zuzuführendes digitales Steuersignal, gekennzeichnet durch

(a) einen auf das Tonfrequenzsignal ansprechenden Nulldetektor (ZD), der ein Ausgangssignal abgibt, wenn ein Momentanwert des Tonfrequenzsignals nahe Null ist, und

(b) einen Zwischenspeicher (LC) zur Zwischenspeicherung des digitalen Steuersignals aus dem Analog/Digital-Wandler (ADC) und zum ununterbrochenen Ausgeben des zwischengespeicherten Steuersignals an den Multiplizierer (MDA; MPY), wobei der Zwischenspeicher (LC) auf das Ausgangssignal des Nulldetektors (ZD) derart anspricht, daß die Zwischenspeicherung nur bei dem Vorliegen des Ausgangssignals erfolgt.

2. Schaltungsanordnung nach Anspruch 1, in der das Tonfrequenzsignal ein analoges Signal ist und der Multiplizierer (MDA; MPY) ein multiplizierender Digital/Analog-Wandler (MDA) zum Multiplizieren des analogen Signals mit dem digitalen Steuersignal und zum Ausgeben eines sich ergebenden analogen Signals ist.

3. Schaltungsanordnung nach Anspruch 1, in der das Tonfrequenzsignal ein digitales Signal ist und der Multiplizierer (MDA; MPY) ein digitaler Multiplizierer (MDY) ist.

4. Schaltungsanordnung nach Anspruch 1, 2 oder 3, in der der Nulldetektor (ZD) derart gestaltet ist, das Ausgangssignal zu erzeugen, wenn der Wert des Tonfrequenzsignals innerhalb eines vorbestimmten Bereichs einschließlich des Nullpegels liegt.

## Revendications

1. Montage de circuit destiné au réglage du volume sonore comprenant: un multiplicateur (MDA ou MPY) réagissant à un signal audio d'entrée servant à régler l'amplitude dudit signal audio en effectuant une multiplication telle que ledit signal audio est multiplié par un signal de commande variable; une partie de manipulation (OP) servant à produire ledit signal de commande variable représentatif du volume sonore désiré dudit signal audio; et un convertisseur analogique/numérique (ADC) servant à convertir ledit signal de commande variable en un signal de commande numérique destiné à être fourni audit multiplicateur, caractérisé en ce qu'il comporte en outre:

(a) un détecteur de zéro (ZD) réagissant audit signal audio servant à produire un signal de sortie lorsqu'une valeur instantanée dudit signal audio est presque égale à zéro; et

(b) un moyen de verrouillage (LC) servant à verrouiller ledit signal de commande numérique en provenance dudit convertisseur analogique/numérique (ADC) et à délivrer le signal de commande verrouillé audit multiplicateur (MDA ou MPY) de façon continue, ledit moyen de verrouillage (LC) réagissant audit signal de sortie en provenance dudit détecteur de zéro (ZD) si bien que le verrouillage n'est effectué qu'en présence dudit signal de sortie.

2. Montage de circuit selon la revendication 1, dans lequel ledit signal audio est un signal analogique et ledit multiplicateur (MDA ou MPY) est un convertisseur numérique/analogique de multiplication (MDA) servant à multiplier ledit signal analogique par ledit signal de commande numérique et à délivrer un signal analogique résultant.

3. Montage de circuit selon la revendication 1, dans lequel ledit signal audio est un signal numérique et ledit multiplicateur (MDA ou MPY) est un multiplicateur numérique (MPY).

4. Montage de circuit selon la revendication 1, 2 ou 3, dans lequel ledit détecteur de zéro (ZD) est prévu pour produire ledit signal de sortie lorsque la valeur dudit signal audio se situe à l'intérieur d'une gamme prédéterminée comprenant le niveau zéro.

# FIG. 1

# FIG. 2

FIG. 3

INPUT AUDIO SIGNAL

ZERO DET OUTPUT

AMPLITUDE-ADJUSTED AUDIO OUTPUT SIGNAL